# EUROPÄISCHE PATENTSCHRIFT

(11) **EP 2 273 094 B1**
(45) Veröffentlichungstag und Bekanntmachung des Hinweises auf die Patenterteilung: **13.08.2014**
(21) Anmeldenummer: 10164566.1
(22) Anmeldetag: 01.06.2010
(51) Int. Cl.: F02G 5/02, F01N 5/02, H01L 35/32, H01L 35/34

(54) **Vorrichtung zur elektrischen Abgaswärmenutzung**
Device for electrical waste gas heat use
Dispositif d'utilisation de la chaleur gaz d'échappement électrique

(30) Priorität: 10.06.2009 DE 102009025046
(43) Veröffentlichungstag der Anmeldung: 12.01.2011
(73) Patentinhaber: Behr GmbH & Co. KG, 70469 Stuttgart (DE)
(72) Erfinder: Brehm, Holger, 71729 Erdmannhausen (DE); Himmer, Thomas, 73326 Reichenbach (Deggingen) (DE); Geskes, Peter, 73760 Ostfildern (DE)
(74) Vertreter: Grauel, Andreas

(56) Entgegenhaltungen:
- DE-A1-102006 039 024
- FR-A1- 2 512 499
- US-A1- 2006 157 102

## Beschreibung

Die vorliegende Erfindung bezieht sich auf eine Vorrichturg zur elektrischen Abgaswärmenutzung gemaß Arspruch 1.

Durch die zunehmende Bestrebung, Fahrzeuge Immer effizienter zu gesfalten und Ksaftsroff einzusparen, ist die Entwicklung neuer Technologien erforderlich. In der Industrie wild derzeit insbesondere die Nutzung der Abgaswärme intensiv diskutiert, da etwa 30% des Energie, die im Kraftstoff gespeichert ist, in Form von Abgaswärme aus dem Fahrzeug geblasen wird. Neben der thermischen Nutzung der Wärmeenergie ist auch die elektrische Nutzung des Abgaswärme möglich über den thermoelektrischen Effekt (Seebeck-Effekt).

In der heutigen Zeit gibt es schon Konzepte, um auf abgasführende Rohre thetmoelektrische Elemente (im Westeren auch als TE bezeichnet) oder Peltierelemente aufzbringen, um elektrische Energie zu nutzen. Bisher sind die Systeme aber hinsichtlich Wärmeübergangs nicht optimal und die erzielten Leistungen sind eher gering. Die Systeme sind in der Regel so aufgebaut, dass TEs, kühlmittelführende Kanäle und abgasführende Kanäle aufeinander gesetzt und verspannt worden. Eine formschlüssige Verbindung ist bisher nicht bekannt. Aus der US-2006/0157102 ist in solches Konzept bekannt.

Der Nachteil der heutigen Lösungen besteht darin, dass der Abgaskühler mit eingebrachten thermoelektrische Elementen (TE) nicht komplett verlötet werden kann, da die TEs normalerweise keine zu hohen Temperaturen (<500°C) aushalten. Um die abgasführenden Bauteile aber miteinander zu verbinden, die in der Regel aus Fdelstahl gefertigt sind, um den hohen Abgastemperaturen standzuhalten, müssten Löttemperaturen von ca. 1100°C gewählt werden. Deshalb gibt es bis heute noch kein einfaches Fertigungskonzept zum Aufbau vor solchen Abgaswärmeübertragem mit integrierten TEs.

Es ist die Aufgabe der vorliegenden Erfindung eine verbesserte Vorrichtung zur eine Vorrichtung zur elektrischen Abgaswärmenutzung und ein entsprechendes Helstellungsverfahron für eine solche eine Vorrichtung zu schaffen.

Diese Aufgabe wird durch ein eine Vorrichtung zur elektrischen Abgaswärmenutzung gemäß Anspruch 1 gelöst.

Ferner schafft die vorliegende Erfindung eine Vorrichtung zur elektrischen Abgaswärmenutzung, wobei die Vorrichtung die folgenden Merkmale aufweist:
- zumindest ein Abgasrohr;
- zumindest ein thermoelektrisches Element (beispielsweist mit einer Ausrichtung dei thermoelektrischen Materialien gemäß einer vorstehenden Ausführungsform eines thermoelektrischen Moduls), und
- wobei im Wechsel Abgasrohre, thermoelektrische Elemente und Kühimittelbehälter, thermoelektrische Elemente und Abgasrohre aufeinander gestapelt sind,
- zumindest einen Kühimittelbehälter, der zur Führung von Kühlmittel ausgebildet ist,
wobei das zumindest eine Abgasrohr, das zumindest eine thermoelektrische Element und der Kühimittelbehalter derart angeordnet sind, dass sich das thermoelektrische Element zwischen dem Abgasrohr und dem Kühlmittelbehälter befindet, wobei das thermoelektriche Element an einer ersten Oberfläche an das Abgasrohr geklebt ist und an einer der ersten Oberfläche gegenüberliegenden zweiten Oberfläche mit dem Kühlmittelbehälter in Kontakt steht. Der Kühlmittelbehälter (120) ist ausgebildet um eine Kühlmittelzufuhr und/oder eine Kühlmittelabfuhr über Kühlmittelkanäle zu ermöglichen, die an einer Stelle seitlich (160, 170) zu einem Stapel bestehend aus den Abgasrohren (105), den thermoelektrischen Elementen (140) und dem Kühlmittelbehälter (120) angeordnet sind.

Der vorliegenden Erfindung liegt die Erkenntnis zu Grunde, dass ein einfacher Ausbau der thermoelektrischen Vorrichtung urd/oder der Vorrichtung zur elektrischen Nutzung der Abgaswärme dann möglich ist, wenn ein Schichtaufbau, speziell aus einem Abgasrohr, einem thermoelektrischen Element und einem Küihimittelbehälter gewählt wird Insbesondere bei einer Klebung des thermoelektrischen Elementes bzw. Moduls und den Abgasrohr kann ein sehr guter Wärmeübergang zwischen dem Abgas und dem thermoelektrischen Element erreicht werden Weiterhin wird das thermoelektrische Element an einer dem Abgasrohr gegenüberliegenden Seite mit einem Kühlmittelbehälter in Kontakt gebracht, so dass das thermoelektrische Element in einem Bereich mit einem möglichst großen Temperaturgradienten angeordnet ist. Auf diese Weise lässt sich durch das große Temperaturgefälle ein Maximum an Abgaswärme zu Erzeugung von elektrischer Energie nutzen und die Herstellung der Vorrichtung zur elektrischen Nutzung der Abgaswärme kann einfach und kostengünstig oh ne die Verwendung einer Schweißung oder Lötung realisiert werden, welche das thermoelektrische Element beschädigen würde. Zusätzlich bietet der hier vorgestellte Ansatz eine einfache und trotzdem sehr sichere Verspannungsmoglichkeit der Komponenten der Vorrichtung durch das Aufschieben von Böden über die Enden der Abgasrohre und/oder den Kuhlmittelbehälter

Die vorliegende Erfindung bietet den Vorteil dass nun eine Einzelfertigung der Einzelkomponeten, insbesondere dem Kühlmittelbehälter und den Abgaskanal, möglich wird Eine solche Einzelfertigung ermöglicht die Anwendung von kostengünstigen Herstellungsverfahren für diese Elemente Die nun einzeln gefertigten Komponenten können nachfolgend vorteilhaft in einer einfachen Montage durch ein Aufstapeln zusammengefügt und verspannt werden. Anschließend kann ein Boden an dem Abgasrohr in den Verbundstapel befestigt werden, wodurch die verspannten Komponenten dauerhaft befestigt werder Durch ein solches drei-stufiges Herstellungsverfahren (beispielsweise unter Verwendung eines Laserschweißens dei Rohr-Boden Verbindung) kann vorteilhaft eine formschlüssige Verbindung realisiert werden Zugleich können durch die Verwendung von beispielsweise Edelstahl für die Abgasrohre und/oder Aluminium für den Kühlmittelbehälter unterschiedliche Materialien für die jeweiligen Elemente der Vorrichtung venwendet werden, je nachdem welche Temperaturbelastung die entsprechenden Elemente aushalten müssen. Dies ermöglicht die Herstellung der Vorrichtung zu reduzierten Kosten durch die Verwendung der jeweils optimal geeigneten und kostengünstigsten Herstellungsmaterialien für die unterschiedlichen Komponenten der Vorrichtung

In einer günstigen Ausführungsform der Erfindung kann im Schritt des Zusammenfügens ein Verspannen des zumindest einen Abgasrohres mit dem thermoelektrischen Element und dem Kühlmittelbehälter speziell unter Verwendung eines Bodens erfolgen. Eine derartige Ausführungsform der vorliegenden Erfindung bietet den Vorteil, dass hierdurch unterschiedliche Komponenten der Vorrichtung einfach, schnell und sicher miteinander verbunden werden können, so dass sich ein kostengünstige Helstellungsplozess ohne die Gefahr einer Beschädigung der thermoelektrischen Elemente realisieren lässt.

Auch kann im Schritt des Bereitstellens zumindest eines Abgasrohres ein Bereitstellen von einer Mehrzahl von gleichartigen Abgasrohren erfolgen und im Schritt des Bereitstellens zumindest eines thermoelektrischen Elements ein Bereitstellen einer Mehrzahl von thermoelektrischen Elementen erfolgen, wobei im Schritt des Zusammenfügens die Abgasrohre und thermoelektrischen Elemente derart angeordnet wenden, dass ein Abgasrohr in Kontakt mit Oberflächen der Mehrzahl von thermoelektrischen Elementen steht und die Oberfläche eines thermoelektrischen Elementes in Kontakt mit der Mehrzahl von Abgasrohren steht Eine solche Ausführungsform der vorliegenden Erfindung bietet den Vorteil, dass Abgasrohre mit kleinerem Querschnitt (und folglich vergleichsweise großer Oherfläche) verwendet werden können, wogegen thermoelektrische Elemente mit großer Oberfläche verwendbar sind Dies ermöglicht eine große Wärmeaustauachfläche zwischen den Abgasrohren und den thermoelektrischen Elementen Zugleich können die thermoelektrischen Elemente mit großer Oberfläche kostengünstig hergestellt werden, so dass sich bei geringen Herstellungskosten ein hoher Wärmenutzungswirkungsgrad erzielen lässt.

In einer weiteren Ausführungsform können im Schritt des Zusammenfügens die thermoelektrischen Elemente über einen Keramik-Klebstoff und/oder eine Wärmeleitpaste mit zumindest einem Abgasrohr thermisch leitfähig verbunden sein und/oder die thermoelektrischen Elemente über einen Keramik-Klebstoff und/oder eine Wärmeleitpaste mit dem Kühlmitelbehälter thermisch leitfähig verburden sein. Eine derartige Ausführungsform der vorliegenden Erfindung bietet den Vorteil der Herstellung einer sehr stabilen und gut wärmeleitenden Verbindung zwischen dem Abgasrohr und dem thermoelektrische Element und/oder dem thermoelektrische Element und dem Kühlmittelbehälter.

Um einen dicht gepackten Stapel von Komponenten in einer entsprechenden Vorrichtug zur elektrischen Nutzung von Abgaswärme bereitzustellen kann im Schritt des Bereitstellens zumindest eines Abgasrohres ein Bereitstellen von einer Mehrzahl von gleichartigen Abgasrohren erfolgen und im Schritt des Bereitstellens zumindest eines thermoelektrischen Elements ein Bereitstellen einer Mehrzahl von thermoelektrischen Elementen erfolgen. Dabei können im Schritt des Zusammenfügens die Abgasrohre, die thermoelektrischen Elemente und der Kühlmittelbehälter derart angeordnet werden, dass sich ein Schichtaufbau ergibt, in dem ein erstes in Abgasrohr mit einem ersten thesmoelektrischen Element in Kontakt ist, das erste thermoelektrische Element mit dem Kühlmittelbehälter in Kontakt ist, der Kühlmittelbehälter mit einem zweiten thermoelektrischen Element in Kontakt ist und das zweite thermoelektrische Element mit einem zweiten Abgasrohr in Kontakt ist Eine derartige Anordnung von unterschiedlichen Abgasrohren, thermoelektrischen Elementen und einem Kühlmittelbehälter ermöglicht auf sehr kleinem Raun große nutzbare Temperaturgradienten Auf diese Weise können die thermoelektrischen Elemente in einem sehr effizienten Arbeitspunkt begeben werden.

Ferner kann auch zumindest ein Abgasrohr als Herstellungsmaterial Stahl umfassen und/oder der Kühlmittelbehälter als Herstellungsmaterial Aluminium umfassen. Eine derartige Ausführungsform der vorliegenden Erfindung bietet den Vorteil, dass das Abgasrohr und/oder den Kühlmittelbehälter ein Material verwendet werden kann, das einerseits die jeweilige erforderliche Temperaturbelastung aushält, jedoch andererseits für die erforderlichen Temperaturanforde rungen sehr kostengünstig ist. Zugleich können die Abgasrohre in einem separaten Prozess hergestellt und bei einer hohen Temperatur verschweißt oder verlötet werden, wogegen der Kuhlmittelbehälter in einem anderen separaten Prozess hergestellt und bei einer niedrigeren Temperatur verschweißt oder verlötet werden kann. Dies ermöglicht die Verwendung von unterschiedlichen, jeweils termperaturmäßig angepassten Herstellungsprozessen die sich kostengünstig implementieren lassen. Weiterhin wird ein thermoelektrisches nicht durch die Herstellungsprozesse des Abgasrohrs oder des Kühlmittelbehälters thermisch zu stark belastet oder beschädigt

Günstig ist es auch, wenn das zumindest eine Abgasrohr zumindest eine Wand aufweist, in die Winglet-Strukturen eingeprägt sind oder an die Rippen angebracht wurden, die in Richtung der Innenseite des Abgasrohres von der Wand des Abgasrohres abstehen Eine derartige Strukturierung zumindest einer Wand eines Abgasrohrs erhöht die Turbulenzen in der Abgasströmung Auf diese Weise kann ein Wärmeaustausch vom Abgas an die Wand des Abgasrohrs verbessert werden.

In einer anderer Ausführungsform der Erfindung kann der Kühlmittelbehälter eine Oberfläche aufweisen, die mit einer Oberfläche von mehreren thermoelektrischen Elementen kontaktierbar ist oder die in Kontakt mit Oberflächen von mehreren thermoelektrischen Elementen steht Eine derartige Ausführungsform der vorliegenden Erfindung bietet den Vorteil, dass in einfacher Weise eine Mehrzahl von thermoelektrischen Elementen gekühlt werden kann, so dass ein möglichst hoher Temperaturgradient über eine möglichst große Wärmeübertragungsfläche aufrechterhalten werden kann.

Sehr günstig ist es, wenn der Kühlmittelbehälter aus zwei Halbschalen gefertigt ist, die miteinander verbunden sind, wobei in einem Innenbereich des Kühlmittelbehälters die Halbschalen durch Abstandsnoppen der einzelnen Halbschalen gegeneinander abgestützt sind. Eine derartige Ausführungsform der vorliegenden Erfindung bietet den Vorteil, dass der Kühlmittelbehälter durch die Fertigung aus zwei Halbschalen sehr einfach, beispielsweise durch ein Prägen oder ein Ziehen eines Aluminiumbleches hergestellt werden kann. Durch ein Verspannen der Vorrichtung werden die zwei Halbschalen aufeinander gepresst, so dass sich der Kühlmittelbehälter sehr einfach realisieren lasst Durch die Abstandsnoppen kann verhindert werden, dass der Kühlmittelbetiälter im Innenbereich beim Zusammenfügen oder Verspannen eingedrückt wird.

Besonders einfach kann der Kühlmittelbehälter abgedichtet werden, wenn die Halbschalen durch einen Dichtungsring miteinander fluiddicht verbunden sind Durch die Verwendung eines solchen Dichtungsrings, der zwischen die Halbschalen gelegt wird, Kann die fluiddichte Abdichtung des Kühlmittelbehälters beim Verspannen sehr einfach erreicht werden.

Auch kann der Kühlmittelbehälter ausgebildet sein, um eine Kühlmittelzufuhr und/oder eine Kühlmittelabfuhr über Kühlmittelkanäle zu ermöglichen, die an einer Stelle seitlich zu einem Stapel bestehend aus den Abgasrohren, den thermoelektrischen Elementen und dem Kühlmittelbehälter angeordnet sind. Eine derartige Ausführungsform der vorliegenden Erfindung bietet den Vorteil, dass die Kühlmittelkanäle nicht durch einen Bereich führen, der einen hohen Temperaturgradienten aufweist. Andernfalls würde durch das Kühlmittel in den Kühlmittelkanälen eventuell eine Abkühlung in diesem Bereich mit dem hohen Temperaturgradienten erfolgen, ohne dass hierdurch elektrische Energie erzeugt weiden konnte Der Wirkungsgrad einer solchen, vorstehend beschriebenen Ausführungsform mit seitlich angeordneten Kühlmittelkanälen bedeutet also eine Verbesserung der Effizienz.

Eine technisch sehr einfache Möglichkeit zum festen Zusammenfügen der Komponenten der Vorrichtung kann dadurch realisiert werden, dass durch die Kühlmittelkanäle zumindest eine Schraube oder zumindest eine andere Zugstrebe geführt ist, um die Vorrichtung zusammenzuspannen.

Eine einfache und sichere Verspannungsmöglichkeit ist ferner auch dann gegeben, wenn zumindest ein Boden vorgesehen ist, der über Enden des zumindest einen Abgasrohres und/oder des Kühlmittelbehälters geschoben wird und der ausgebildet ist, um einen Druck auf einen Stapel auszuüben, der aus dem zumindest einen Abgasrohr, dem zumindest einen thermoelektrische Element und dem Kühlmittelbehälter besteht.

Bevorzugte Ausführungsbeispiele der vorliegenden Erfindung werden nachfolgend Bezug nehmend auf die beiliegenden Zeichnungen naher erläutert. Es zeigen:
- Fig. 1: eine Schnittdarstellung eines ersten Ausführungsbeispiels der vorlie- genden Erfindung in Querschnittansicht;
- Fig 2: eine Schnittdarstellung des ersten Ausführungsbeispiels der vorliegen- den Erfindung in Aufsicht,
- Fig. 3: eine isometrische Darstellung oer Komponenten des ersten Ausfüh- rungsbeispiels der vorliegenden Erfindung;
- Fig 4: eine isometrische Darstellung einer Mehrzahl von Abgasrohren mit ei- nem daran befestigten Bodenteil; und
- Fig. 5: ein Ablaufdiagramm eines Ausführungsbeispiels der vorliegenden Er- findung als Verfahren.

In der nachfolgenden Beschreibung der bevorzugten Ausführungsbeispiele der vorliegenden Erfindung werden für die n den verschiedenen Zeichnungen dargestellten und ähnlich wirkenden Elemente gleiche oder ähnliche Bezugszeichen verwendet, wobei eine wiederholte Beschreibung dieser Elemente weggelassen wird Umfasst ein Ausführungsbeispiel eine "und/oder" Verknüpfung zwischen einem ersten Merkmal und einem zweites Merkmal, so kann dies so ge lesen werden, dass das Ausführungsbeispiel gemäß einer Ausführungsform sowohl das erste Merkmal als auch das zweite Merkmal und gemäß einer weiteren Ausführungsform entweder nur das erste Merkmal oder nur das zweite Merkmal aufweist. Die beschriebenen Ausführungsbeispiele sind nur beispielhaft gewählt und können miteinander kombiniert werden.

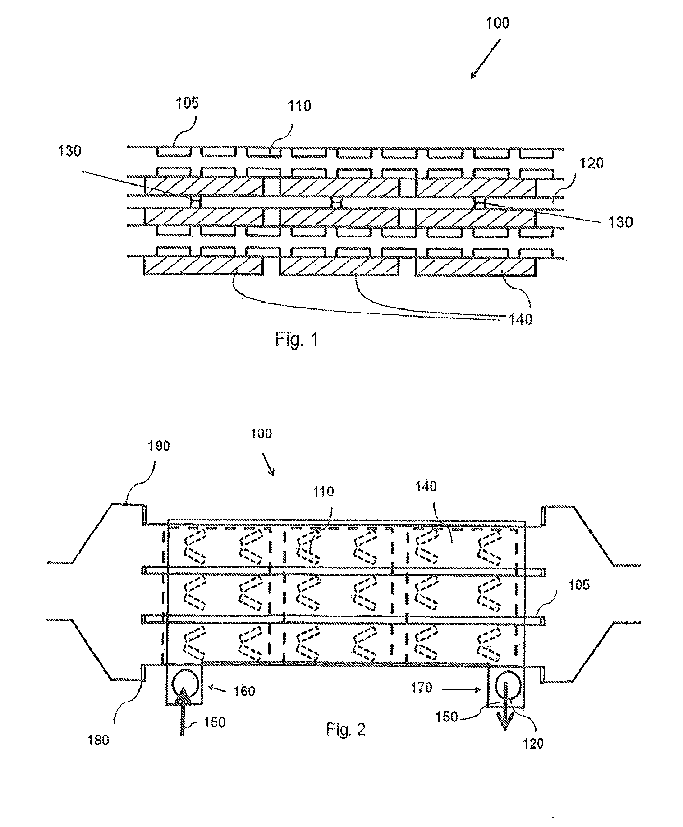

Die Idee, die dieser Erfindung zugrunde liegt, sieht auch einen Schichtaufbau für die Vorrichtung zur elektrischen Abgaswärmenutzung vor. Fig. 1 zeigt eine Schnittdarstellung eines ersten Ausführungsbespiels der vorliegenden Erfindung als Vorrichtung zur elektrischen Abgaswärmenutzung in Querschnittansicht. Das Abgas wird in Kanälen oder Rohren 105 geführt die beispielsweise aus Edelstahl hergestellt werden, um die hohen Abgastemperaturen auszuhalten Diese abgasführenden Kanäle 105 können aus Halbschalen oder aus einem Blech gefertigt werden. Die Rohre 105 besitzen beispielsweise eingeprägte Wingelts 110 oder eingeschobene und verlötete Rippen. Die Rohre 105 werden im Fall von eingeschobenen Rippen einzeln im Ofen bei bis zu 1100 °C gelötet. Bei eingeprägten Winglets 110 wird nur das Blech mit Wingelts 110 versehen und dann durch einen Rollensatz umgeformt und an der Längsnaht lasergeschweit. Dies ist ein Endlosprozeß.

Parallel zu der Herstellung der Einzelrohre 105, die zwischen 2 und 10 mm hoch und zwischen 10 und 100 mm breit sein können, werden auch die kühlmittelführenden Kanäle 120 (d h der Kühlmittelbehälter), z B zwei tiefgezogene Aluminiumbleche mit Abstütznoppen 130 in einem Aluminium-Lötprozeß bei ca. 600°C miteinander verlötet Unter einem Kühlmittelbehälter 120 ist in dieser Anmeldung ein Behälter zu verstehen, der nicht notwendigerweise bei Auslieferung oder Einbau in eine andere Einheit bereits mit Kühlmittel gefüllt ist, vielmehr muss der Kühlmittelbehälter lediglich zur Führung eines solchen Kühlmittels ausgebildet sein.

Falls möglich, können auch die TEs (beispielsweise Peltierelemente) 140 auf beiden Seiten des Kühlmittelkanals 130 mit auf das Aluminium verlötet werden Hierbei ist zu beachten, dass die TEs 140 auf beiden Seiten eine Keramikplatte aufweist, die in diesem Fall mit dem Aluminium verlöten sollte. Die elektrische Verdrahtung sollte bei diesem gemeinsamen Verlöten von TE 140 und Alu-Scheiben 120 oder Kanal erst später erfolgen, da eine thermische Behandlung der Kabel nicht moglich ist, ohne sie zu zerstören.

Die TEs 140 werden über Keramikkleber oder Wärmeleitpaste an die Abgasrohre geklebt und dann die Alu-Kühlmittelscheibe ebenfalls auf die TE 140 verklebt, falls nicht schon vorher eine Lötverbindung zwischen Aluminium und TE 140 hergestellt worden ist. In Fig. 1 ist ein einfacher Verbund 100 gezeigt

Je nach Bauraum werden also gemäß einem Ausfühfungsbeispiel günstigerweise im Wechsel Abgasrohre 105, TEs 140, Kühlmittelkanal 120, TEs 140, Abgasrohre 105 usw aufeinandergestapelt, wobei ein Kühlmittel 150 seitlich zuführbar sein sollte. In Fig. 2 ist eine Schnittdarstellung des ersten Ausfuhrungsbeispiels dei vorliegenden Erfindung als Vorrichtung zur elektrischen Abgaswärmenutzung in Aufsicht wiedergegeben, in der der Verbund 100 von oben gezeigt ist. Aus Fig. 2 ist ersichtlich, dass hier als Kühlmittelkanal oder Kühlmittelbehälter 120 ein Scheibenpaar aus Aluminium so ausgeführt wurde, dass das Kühlmittel 150 vorne und hinten über einen herausstehenden Bereich 160 bzw 170 zu- und abgeführt werden kann. Weiterhin Kann seitlich an den Abgasrohren 105 ein Boden 180 befestigt sein, der den Verbund 100 auf Spannung zusammengedrückt hält Auch kann an den Böden 180 seitlich noch ein oder mehrere Diffuseren 190 angebracht sein, um eine optimale Aufteilung des anströmenden Abgases auf die einzelnen Abgasrohre 105 bewerkstelligen zu können.

Anstelle einer Scheibe 120 ist es auch denkbar, daß ein extrudiertes Aluminiumprofil als Kühlmitielkanal verwendet wird.

Die kühlmittelführenden Kanäle 120 brauchen nicht zwangsläufig aus Aluminium gefertigt sein, sie können auch aus Edelstahl hergestellt werden

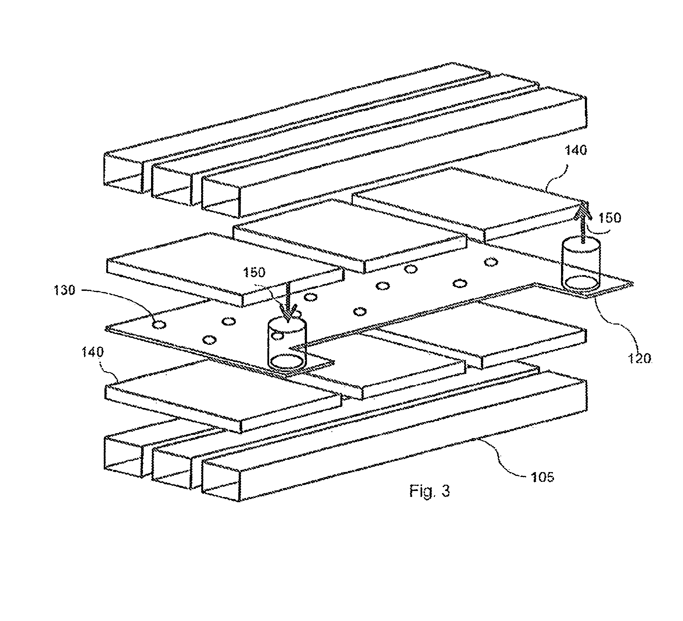

Bei der Herstellung des Verbundes 100 wird dieser nun zusammengesetzt, gespannt und anschließend die beiden Böden 180 auf die Abgasrohre 105 aufgeschoben Um den Verbund 100 als Vorrichtung zur elektrischen Abgaswärmenutzung zusammenzusetzen, können die einzelnen Komponenten entspre chend der isometrischen Darstellung aus Fig. 3 zusammengefügt werden Insbesondere wird aus der Darstellung gemäß Figur 3 ersichtlich dass die Abgasrohre zueinander parallelen angeordnet werden, wogegen die Längsachse der thermcelektrischen Elemente 140 quer zur Erstreckungsrichtung der Abgasrohre 105 angeordnet werden Auf diese Weise kann erreicht werben, dass Abgasrohre 105 mit kleinem Querschnitt n KontaKt mit thermoelektrischen Elementen 140 kommen, die eine große Oberfläche haben. Hierdurch lässt sich ein hoher Temperaturgradient über eine große Kontaktfläche erreichen, so dass günstige Arbeitsbedingungen zur Energieumwandlung von Abgaswärme in elektrische Energie bestehen.

Auch können die mehreren thermoelektrische Elemente 140, die beispielsweise als Peltierelement ausgestattet sind, mit einer sehr großen Oberfläche des Kühlmittelbehälters 120 in thermischem Kontakt stehen, so dass die thermoelektrische Elemente 140 zwischen den Abgasrohren 105 und dem Kühlmittelbehälter 120 angeordnet sind und über große Flächenbereiche ein hoher Temperaturgradient aufrecht erhalten werden kann

Wie aus der Darstellung gemäß Fig. 3 ersichtlich ist, kann der Kühlmittelbehälter 120 zwei Aluminiumscheiben zur Führung des Kühlmittels 170 umfassend Um ein Zusammendrücken diese Aluminiumscheiben beim Verspannen zu verhindern, können Abstütznoppen 130 In die Aluminiumscheiben (oder die Scheiben aus einem anderen Material wie Edelstahl) eingeprägt werden an, die sich beim Zusammenfügen auf entsprechenden Abstutznoppen 130 der gegenüberlegen deren Scheibe abstützen. Um den Kuhlmittelbehälter 120 fluiddicht auszugestalten, so dass im Betrieb Kein Kühlmittel 170 zwischen den Scheiben austritt, sollte vor dem Zusammenfügen am Rande dieser Scheiben ein Dichtungsring zwischen die beiden Scheiben gelegt wenden, der beispielsweise aus einem elastischen Material wie Gummi oder Kautschuk bestehen kann

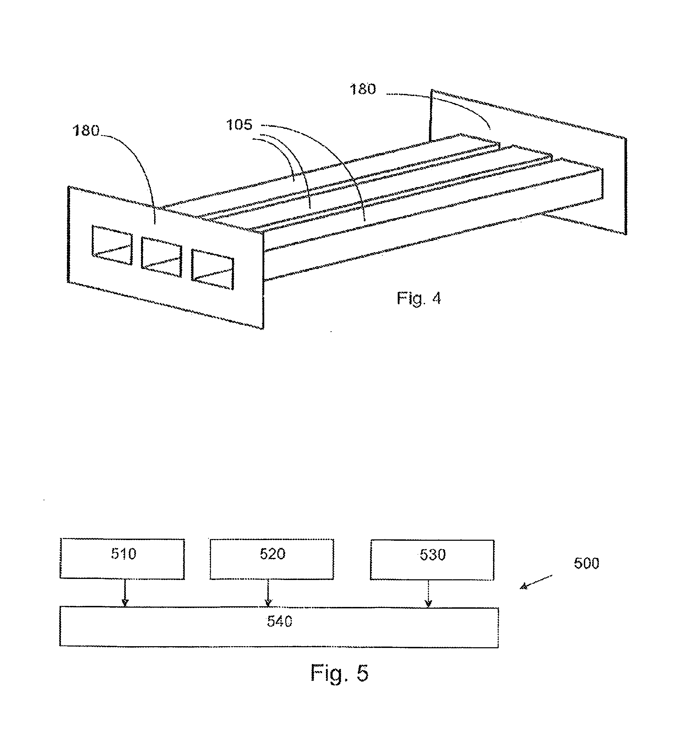

Die Verbindung aus Abgasrohren 105 und Boden 190 wird idealerweise mittels Laserschweißen hergestellt Denkbar ist auch, dass die Rohre 105 schon einen Teil des Bodens 180 besitzen (z B durch vorheriges Anlöten oder Srhweißen), so dass als Rohre 105 eine Einheit verwendet wird Wie s.e in Fig. 4 gezeigt ist Diese Einheit wird dann mit TEs und einem Kühlmittellanal verbunden und stellt eine Teileinheit dar. Die Verschweißung der Einzelteile der Boden erfolgt dann nach Verspannen des gesamten Verbundes.

Bei der Kühmittelverteliung ist es wichtig, dass die Kühlmittelkanäle untereinander dicht miteinander verbunden sind. Hierzu sollte die Scheibe 120 mit einem Ring verlötet werden oder die Scheibe ist so umgeformt sein, dass sie einen Napf ausbildet Die Ringe bzw Napfe der benachbarten Scheiben sollten mittels Dichtung und Verspannen verbunden werden, Dies ist in Fig. 3 gezeigt. Durch den Kühlmittelkanal 180 könnte z.B. eine Schraube geführt werden, um die Vorrichtung zu verspannen.

Auf den Boden 180 kann beispielsweise noch der Abgasdiffusor 190 ein- und austrittsseitig aufgeschweißt werden (siehe auch Fig 3) und um den Verbund 100 kann noch ein (hier nicht dargestelltes) Gehäuse montiert werden, um die Druckfestigkeit der Rohre 105 gegenüber dem Ahgasdruck zu erreichen. Alternativ konnte auch einfach Zupstreben so montiert werden, dass der Verbund 105 verspannt wird

Fig. 5 zeigt ein Ablaufdiagramm eines Ausführungsbeispiels der Erfindung als Verfahren 500 zur Herstellung einer Vorrichtung 100 zur elektrischen Abgaswärmenutzung, wobei das Verfahren 500 einen Schritt des Bereitstellens 510 zumindest eines Abgasrohres und einen Schritt eines Bereitstellens 520 von zumindest einem thermoelektrischen Element Ferner weist das Verfahren 500 einen Schritt des Bereitstellens 530 von zummindest einem Kühlmittelbehälter auf, der zur Führung von Kühlmittel ausgebildet ist Schließlich umfasst das Verfahren 500 einen Schritt des Zusammenfügens 540 des Abgasrohres, des thermoelektrischen Elementes und des Kühlmittelbehälters zur Herstellung der Vorrichtung zur elektrischen Abgaswärmenutzung, derart, das sich das thermoelektrische Element zwischen dem Abgasrohr und dem Kühlmittelbehälter befindet, wobei beim Zusammenfügen das thermoelektrische Element an einer ersten Oberfläche an das Abgasrohr geklebt wird und an einer der ersten Oberfläche gegenüberliegenden zweiten Oberfläche mit dem Kühlmittelbehälter in Kontakt gebracht wird.

## Patentansprüche

1. Vorrichtung (100) zur elektrischen Abgaswärmenutzung, wobei die Vorrichtung (100) die folgenden Merkmale aufweist:
- zumindest ein Abgasrohr (105);
- zumindest ein thermoelektrisches Element (140); und
- zumindest einen Kühlmittelbehälter (120), der zur Führung von Kühlmittel (150) ausgebildet ist,
- wobei im Wechsel Abgasrohre, thermoelektrische Elemente und Kahlmittelbehälter, thermoelektrische Elemente und Abgasrohre aufeinander gestapelt sind,
wobei das zumindest eine Abgasrohr (105), das zumindest eine thermoelektrische Element (140) und der Kühlmittelbehälter (120) derart angeordnet sind, dass sich das thermoelektrische Element (140) zwischen dem Abgasrohr (105) und dem Kühlmittelbehälter (120) befindet und an einer ersten Oberfläche an das Abgasrohr (105) geklebt ist und das thermoelektrische Element (140) an einer zweiten, der ersten Oberfläche gegenüberliegenden zweiten Oberflächen mit dem Kühlmittelbehälter (120) in Kontakt steht, **dadurch gekennzeichnet, dass** der Kühlmittelbehälter (120) ausgebildet ist, um eine Kühlmittelzufuhr und/oder eine Kühlmittelabfuhr über Kühlmittelkanäle zu ermöglichen, die an einer Stelle seitlich (160, 170) zu einem Stapel bestehend aus den Abgasrohren (105), den thermoelektrischen Elementen (140) und dem Kühlmittelbehälter (120) angeordnet sind.

2. Vorrichtung (100) gemäß Anspruch 1, **dadurch gekennzeichnet, dass** zumindest ein Abgasrohr (105) als Herstellungsmaterial Stahl umfasst und/oder dass der Kühlmittelbehälter (120) als Herstellungsmaterial Aluminium umfasst.

3. Vorrichtung (100) gemäß einem der Ansprüche 1 oder 2, **dadurch gekennzeichnet, dass** das zumindest ein Abgasrohr (105) zumindest eine Wand aufweist, in die Winglet-Strukturen (110) eingeprägt sind oder an die Rippen angebracht wurde, die in Richtung der Innenseite des Abgasrohres (105) von der Wand des Abgasrohres (105) abstehen.

4. Vorrichtung (100) gemäß einem der Ansprüche 1 bis 3, **dadurch gekennzeichnet, dass** der Kohlmittelbehäfter (120) Oberfläche aufweist, die mit einer Oberfläche von mehreren thermoelektrischen Elementen (140) kontaktierbar ist oder die in Kontakt mit Oberflächen von mehreren thermoelektrischen Elementen (140) steht.

5. Vorrichtung (100) gemäß einem der Ansprüche 1 bis 4, **dadurch gekennzeichnet, dass** der Kühlmittelbehälter (120) aus zwei Halbschalen oder Scheiben gefertigt ist, die miteinander verbunden sind, wobei in einem Innenbereich des Kühlmittelbehälters (120) die Halbschalen oder Scheiben durch Abstandsnoppen (130) der einzelnen Halbschalen oder Scheiben gegeneinander abgestützt sind.

6. Vorrichtung (100) gemäß Anspruch 5, **dadurch gekennzeichnet, dass** die Halbschalen oder Scheiben des Kühlmittelbehälters (120) durch einen Dichtungsring miteinander fluiddicht verbunden sind.

7. Vorrichtung (100) gemäß einem der Ansprüche 1 bis 6, **dadurch gekennzeichnet, dass** durch die Kühlmittelkanäle zumindest eine Schraube oder zumindest eine andere Zugstrebe geführt ist, um die Vorrichtung (100) zusammenzuspannen.

8. Vorrichtung (100) gemäß einem der Ansprüche 1 bis 7, **dadurch gekennzeichnet dass** ferner zumindest ein Boden (180) vorgesehen ist, der über Enden des zumindest einen Abgasrohres (105) und/oder des Kühlmittelbehälters (120) geschoben ist und der ausgebildet ist, um einen Druck auf einen Stapel auszuüben, der das zumindest eine Abgasrohr (105), das zumindest eine thermoelektrischen Element (140) und den Kühlmittelbehälter (120) umfasst.

## Claims

1. A device (100) for electrical waste gas heat use, wherein the device (100) has the following features:
- at least one waste gas pipe (105);
- at least one thermoelectric element (140); and
- at least one coolant container (120), which is configured to guide coolant (150),
- wherein waste gas pipes, thermoelectric elements and coolant containers, thermoelectric elements and waste gas pipes are stacked on one another alternately, wherein the at least one waste gas pipe (105), the at least one thermoelectric element (140), and the coolant container (120) are arranged in such a way that the thermoelectric element (140) is located between the waste gas pipe (105) and the coolant container (120) and is bonded to the waste gas pipe (105) at a first surface, and the thermoelectric element (140) is in contact with the coolant container (120) at a second surface, which is opposite the first surface, **characterised in that** the coolant container (120) is configured to enable a coolant feed and/or a coolant removal via coolant channels, which are arranged at a point laterally (160, 170) with respect to a stack consisting of the waste gas pipes (105), the thermoelectric elements (140) and the coolant container (120).

2. The device (100) according to claim 1, **characterised in that** the at least one waste gas pipe (105) comprises steel as material of production, and/or **in that** the coolant container (120) comprises aluminium as material of production.

3. The device (100) according to one of claims 1 or 2, **characterised in that** the at least one waste gas pipe (105) has at least one wall, into which winglet structures (110) are impressed or to which ribs have been attached, which protrude from the wall of the waste gas pipe (105) in the direction of the inner face of the waste gas pipe (105).

4. The device (100) according to one of claims 1 to 3, **characterised in that** the coolant container (120) has a surface that can be contacted with a surface of a plurality of thermoelectric elements (140) or that is in contact with surfaces of a plurality of thermoelectric elements (140).

5. The device (100) according to one of claims 1 to 4, **characterised in that** the coolant container (120) is fabricated from two half shells or plates, which are interconnected, wherein the half shells or plates are supported against one another in an inner region of the coolant container (120) by means of spacing nubs (130) of the individual half shells or plates.

6. The device (100) according to claim 5, **characterised in that** the half shells or plates of the coolant container (120) are interconnected in a fluid-tight manner by a ring seal.

7. The device (100) according to one of claims 1 to 6, **characterised in that** a screw or at least one other tensioning element is guided through the coolant channels in order to draw the device (100) together.

8. The device (100) according to one of claims 1 to 7, **characterised in that** at least one base (180) is also provided, which is slid over ends of the at least one waste gas pipe (105) and/or of the coolant container (120) and which is configured to exert a pressure onto a stack comprising the at least one waste gas pipe (105), the at least one thermoelectric element (140) and the coolant container (120).

## Revendications

1. Dispositif (100) servant à l'utilisation électrique de la chaleur des gaz d'échappement, où le dispositif (100) présente les caractéristiques suivantes:
- au moins un tuyau de gaz d'échappement (105);
- au moins un élément thermoélectrique (140); et
- au moins un réservoir de liquide de refroidissement (120) qui est conçu pour l'acheminement de liquide de refroidissement (150),
- où sont empilés les uns sur les autres, de façon alternée, des tuyaux de gaz d'échappement, des éléments thermoélectriques et des réservoirs de liquide de refroidissement, des éléments thermoélectriques et des tuyaux de gaz d'échappement, où le tuyau de gaz d'échappement (105) au moins au nombre de un, l'élément thermoélectrique (140) au moins au nombre de un et le récipient de liquide de refroidissement (120) sont disposés de manière telle, que l'élément thermoélectrique (140) se trouve entre le tuyau de gaz d'échappement (105) et le récipient de liquide de refroidissement (120) et est collé, sur une première surface, sur le tuyau de gaz d'échappement (105), et l'élément thermoélectrique (140), au niveau d'une seconde surface opposée à la première surface, est au contact du réservoir de liquide de refroidissement (120),
**caractérisé en ce que** le réservoir de liquide de refroidissement (120) est conçu pour permettre une alimentation en liquide de refroidissement et/ou une évacuation du liquide de refroidissement via des conduits de liquide de refroidissement qui sont disposés au niveau d'un emplacement situé latéralement (160, 170) par rapport à un empilement se composant des tuyaux de gaz d'échappement (105), des éléments thermoélectriques (140) et du récipient de liquide de refroidissement (120).

2. Dispositif (100) selon la revendication 1, **caractérisé en ce qu'**au moins un tuyau de gaz d'échappement (105) comprend de l'acier utilisé comme matériau de fabrication, et/ou **en ce que** le récipient de liquide de refroidissement (120) comprend de l'aluminium utilisé comme matériau de fabrication.

3. Dispositif (100) selon l'une des revendications 1 ou 2, **caractérisé en ce que** le tuyau de gaz d'échappement (105) au moins au nombre de un présente au moins une paroi dans laquelle sont matricées des structures de winglets (110), ou bien sur laquelle ont été fixées des ailettes qui s'écartent de la paroi du tuyau de gaz d'échappement (105), en direction du côté intérieur du tuyau de gaz d'échappement (105).

4. Dispositif (100) selon l'une quelconque des revendications 1 à 3, **caractérisé en ce que** le réservoir de liquide de refroidissement (120) présente une surface qui peut venir au contact d'une surface de plusieurs éléments thermoélectriques (140) ou bien qui est au contact de surfaces de plusieurs éléments thermoélectriques (140).

5. Dispositif (100) selon l'une quelconque des revendications 1 à 4, **caractérisé en ce que** le réservoir de liquide de refroidissement (120) est fabriqué en se composant de deux demi-coques ou flans qui sont assemblé(e)s l'une à l'autre ou l'un à l'autre, où, dans une zone intérieure du réservoir de liquide de refroidissement (120), les demi-coques ou flans sont en appui les unes contre les autres ou les uns contre les autres par des tétons supports (130) des différentes demi-coques ou des différents flans.

6. Dispositif (100) selon la revendication 5, **caractérisé en ce que** les demi-coques ou flans du réservoir de liquide de refroidissement (120) sont assemblé(e)s l'une à l'autre ou l'un à l'autre, de façon fluidiquement étanche, par une bague d'étanchéité.

7. Dispositif (100) selon l'une quelconque des revendications 1 à 6, **caractérisé en ce qu'**au moins une vis ou au moins un autre tirant est guidé (e) à travers les conduits de liquide de refroidissement, pour serrer l'ensemble du dispositif (100).

8. Dispositif (100) selon l'une quelconque des revendications 1 à 7, **caractérisé en ce qu'**il est prévu en outre au moins un fond (180) qui est déplacé par-dessus des extrémités du tuyau de gaz d'échappement (105) au moins au nombre de un et/ou du réservoir de liquide de refroidissement (120) et qui est conçu pour exercer une pression sur un empilement qui comprend le tuyau de gaz d'échappement (105) au moins au nombre de un, l'élément thermoélectrique (140) au moins au nombre de un et le réservoir de liquide de refroidissement (120).
